# EUROPÄISCHE PATENTSCHRIFT

(11) **EP 3 203 252 B1**
(45) Veröffentlichungstag und Bekanntmachung des Hinweises auf die Patenterteilung: **21.06.2023**
(21) Anmeldenummer: 17000108.5
(22) Anmeldetag: 23.01.2017
(51) Int. Cl.: G01R 31/36, G01R 19/165

(54) **SCHALTUNGSANORDNUNG ZUR BESTIMMUNG DER ZELLSPANNUNG EINER EINZELZELLE IN EINEM ZELLVERBUND**
CIRCUIT ASSEMBLY FOR DETERMINING THE CELL VOLTAGE OF A SINGLE CELL IN A CELL ASSEMBLY
SYSTÈME DE CIRCUIT SERVANT À DÉTERMINER LA TENSION D'UNE CELLULE INDIVIDUELLE DANS UN GROUPEMENT DE CELLULES

(30) Priorität: 30.01.2016 DE 102016001057
(43) Veröffentlichungstag der Anmeldung: 09.08.2017
(73) Patentinhaber: Andreas Stihl AG & Co. KG, 71336 Waiblingen (DE)
(72) Erfinder: Schurr, Martin, 73557 Mutlangen (DE); Liebhard, Gernot, 71332 Waiblingen (DE); Heigemeyr, Christian, 86676 Ehekirchen (DE); Kulzer, Markus, 85117 Eitensheim (DE)
(74) Vertreter: Wasmuth, Rolf

(56) Entgegenhaltungen:
- EP-A2- 2 122 380
- DE-A1-102014 204 959
- DE-B4-102007 049 528
- FR-A1- 3 039 006
- JP-A- 2002 286 766
- US-A1- 2004 051 534

## Beschreibung

Die Erfindung betrifft eine Schaltungsanordnung zur Bestimmung der Zellspannung einer Einzelzelle in einem Zellverbund eines Akkupacks nach dem Oberbegriff des Anspruchs 1.

Aus der DE 10 2007 049 528 B4 ist eine Schaltungsanordnung zur Messung der Zellspannungen von Einzelzellen eines Akkupacks bekannt. Die Einzelzellen bilden einen Zellverbund aus einer Reihenschaltung von Einzelzellen, wobei zwischen elektrisch benachbarten Einzelzellen der Reihenschaltung Potenzialpunkte ausgebildet sind. Die Potenziale der in der Reihenschaltung aufeinander folgenden Potenzialpunkte wachsen ausgehend von einem Bezugspotenzial im Betrag an. Jeder Potenzialpunkt der Reihenschaltung ist über einen Messwiderstand und einen Schalter mit einem Messeingang einer Auswertevorrichtung verbunden. Am Messwiderstand fällt nach Schließen des Schalters eine Spannung ab, die von der Auswertevorrichtung erfasst wird. Die einem Potenzialpunkt zugeordneten Messwiderstände sind nach Art einer Widerstandskaskade in Reihe geschaltet und bilden eine ohmsche Last der zu messenden Einzelzellen. Dabei bilden bei einer Messung der ersten Einzelzelle der Reihenschaltung der geschlossene Schalter und der erste Messwiderstand mit der ersten Einzelzelle einen ersten elektrischen Messkreis. Wird der zweite Schalter geschlossen - alle anderen Schalter sind offen -, bilden die erste Einzelzelle, die zweite Einzelzelle, der erste Messwiderstand und der zweite Messwiderstand einen geschlossenen Messkreis. Mit jeder Messung wird eine Einzelzelle elektrisch belastet, wobei die Belastung der ersten Einzelzellen einer Reihenschaltung größer ist als die der letzten Einzelzellen der Reihenschaltung. Die Einzelzellen werden jeweils durch Schließen der einzelnen Schalter gemessen, wobei jeweils die am Messwiderstand abfallende Spannung erfasst und ausgewertet wird.

Die US 2004/0051534 A1, die EP 2 122 380 A2 und die JP 2002 286 766 A1 zeigen ähnliche Schaltungsanordnungen zur Messung der Zellspannung einer Einzelzelle in einem Zellverbund.

Der Aufwand einer derartigen Schaltungsanordnung zur Einzelspannungsmessung ist hoch; da die gemessenen Spannungen unter ohmscher Last erfasst werden, sind die Einzelzellen elektrisch stark belastet, wodurch die Standzeit des Akkupacks beeinflusst sein kann.

Der Erfindung liegt die Aufgabe zugrunde, eine Schaltungsanordnung zur Bestimmung der Zellspannung einer Einzelzelle in einem Zellverbund aus einer Reihenschaltung von Einzelzellen eines Akkupacks anzugeben, welche einfach aufgebaut ist und eine geringe elektrische Belastung der Einzelzellen während der Messung aufweist.

Die Aufgabe wird nach den Merkmalen des Anspruchs 1 gelöst.

Der Messeingang der Auswertevorrichtung ist über einen Kondensator mit dem Bezugspotenzial verbunden, wobei die Auswertevorrichtung die Ladezeit des Kondensators auf eine vorgegebene Messspannung erfasst. Die Auswertevorrichtung bestimmt anhand der Ladezeit des Messkondensators die Zellspannung der gemessenen Einzelzelle.

Vorteilhaft wird die Ladezeit des Messkondensators auf die Messspannung in einfacher Weise mittels eines Zählers erfasst, der mit dem Beginn der Messung anläuft und bei Erreichen der vorgegebenen Messspannung stoppt. Durch den Zähler wird in einfacher Weise unmittelbar die Ladezeit des Messkondensators in Zähleinheiten erfasst, wobei die Menge der Zähleinheiten vorzugsweise groß gewählt ist. So kann z. B. das Erreichen der Messspannung mit einem Zählerstand von mehreren Tausend oder Zehntausend gezählten Einheiten ausgelegt werden, was ohne großen technischen Aufwand eine hohe Auflösung ermöglicht. Gegenüber bekannten A/D Wandlern kann so eine hohe Genauigkeit erzielt werden.

Der Zählerstand des Zählers ist der Ladezeit des Messkondensators auf die Messspannung proportional. Dabei kann die Zähleinheit des Zählers einer vorgegebenen festen Zeiteinheit entsprechen. In einfacher Weise zählt der Zähler die Impulse eines Zeitgliedes.

Die Kondensatorspannung des Messkondensators wird auf einen ersten Eingang eines Komparators geschaltet, auf dessen zweiten Eingang ein Referenzwert entsprechend der vorgegebenen Messspannung aufgeschaltet ist. Der Ausgang des Komparators kann in einfacher Weise als Steuerungssignal auf den Zähler geschaltet sein. Der Ausgang des Komparators startet und stoppt den Zähler.

Die Auswertevorrichtung zur Umrechnung des Zählerstandes in die Zellspannung der gemessenen Einzelzelle ist vorteilhaft in einem Mikroprozessor ausgebildet. In diesem Mikroprozessor kann auch der Zähler als integriertes Bauteil ausgeführt sein. Der Komparator ist zweckmäßig ein integriertes Bauteil des Mikroprozessors. Das Zeitglied wird von der "Clock" des Mikroprozessors gebildet, dessen Impulsfolge von dem Zähler gezählt wird.

Vorteilhaft ist die vorgegebene Messspannung kleiner, insbesondere etwa 10% bis 95% kleiner als die Zellspannung einer vollständig geladenen Einzelzelle, so dass die elektrische Belastung der Einzelzelle während des Messvorgangs gering ist. Liegt die Zellspannung einer Einzelzelle im geladenen Zustand bei etwa 4,2 Volt, so kann die vorgegebene Messspannung z. B. bei nur 2000 mV liegen. Vorteilhaft liegt die vorgegebene Messspannung, die auch als Referenzwert zum Vergleich herangezogen wird, bei 1000 mV.

Weitere Merkmale der Erfindung ergeben sich aus den weiteren Ansprüchen, der Beschreibung und der Zeichnung, in der ein Ausführungsbeispiel der Erfindung dargestellt ist. Es zeigen:
- Fig. 1: in schematischer Darstellung eine Schaltungsanordnung zur Bestimmung der Zellspannung einer Einzelzelle in einem Zellverbund,
- Fig. 2: in schematischer Darstellung ein Blockschaltbild einer Auswertevorrichtung,
- Fig. 3: in schematischer Darstellung den Spannungsverlauf der Kondensatorspannung des Messkondensators.

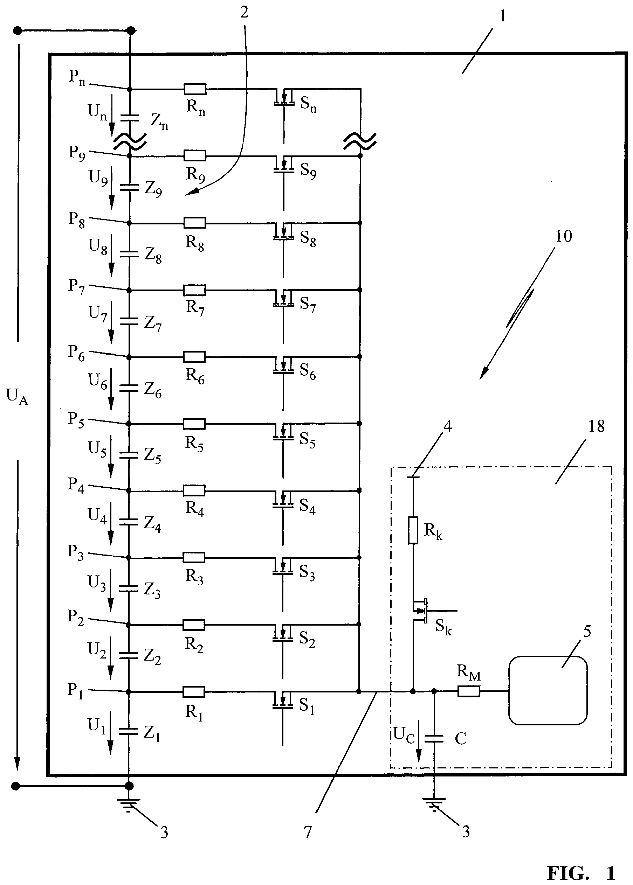

In Fig. 1 ist ein Ausführungsbeispiel einer Schaltungsanordnung 10 von Einzelzellen Z₁, Z₂, Z₃, Z₄, Z₅, Z₆, Z₇, Z₈, Z₉ bis Zₙ innerhalb eines Akkupacks 1 schematisch wiedergegeben. Die Einzelzellen Z₁ bis Zₙ sind in einer Reihenschaltung 2 hintereinander geschaltet und stellen als Summenspannung gemeinsam eine Akkupackspannung U_{A} zur Verfügung. Die Akkupackspannung U_{A} setzt sich zusammen aus den Einzelspannungen U₁, U₂, U₃, U₄, U₅, U₆, U₇, U₈, U₉ bis Uₙ. Die Einzelzellen Z₁ bis Zₙ bilden einen Zellverbund des Akkupacks.

Die Reihenschaltung 2 weist nach jeder Einzelzelle Z₁ bis Zₙ einen Potenzialpunkt P₁, P₂, P₃, P₄, P₅, P₆, P₇, P₈, P₉ bis Pₙ auf, wobei - wie an den Spannungspfeilen U₁ bis Uₙ zu ersehen - die Potenziale der in der Reihenschaltung 2 aufeinander folgenden Potenzialpunkte P₁ bis Pₙ ausgehend von einem Bezugspotenzial 3 anwachsen. Das Bezugspotenzial 3 ist vorzugsweise das Massepotenzial.

Jeder Potenzialpunkt P₁ bis Pₙ ist über einen Messwiderstand R₁, R₂, R₃, R₄, R₅, R₆, R₇, R₈, R₉ bis Rₙ und einen Schalter S₁, S₂, S₃, S₄, S₅, S₆, S₇, S₈, S₉ bis Sₙ mit einem Messeingang 7 einer Auswertevorrichtung 5 verbunden.

Im Folgenden wird das Bezugszeichen Zᵢ, Pᵢ, Uᵢ, Sᵢ, Rᵢ mit dem Index i allgemein für die Bezugszeichen Z₁, Z₂, ... Zₙ, P₁, P₂, ... Pₙ, U₁, U₂, ... Uₙ, S₁, S₂, ... Sₙ, R₁, R₂, ... Rₙ, verwendet, wobei i für eine natürliche Zahl von 1 bis n steht. Beispielsweise ist so Zᵢ als (Zᵢ) mit i = 1, 2, 3, ...., n definiert.

Aufgrund der dargestellten Schaltungsanordnung 10 liegen mit Schließen z. B. des Schalters S₇ die Einzelspannungen U₁, U₂, U₃, U₄, U₅, U₆ und U₇ der Teilreihenschaltung der Einzelzellen Z₁, Z₂, Z₃, Z₄, Z₅, Z₆ und Z₇ als Summenspannung am Kondensator C an. Um unabhängig von dem gewählten Schalter Sᵢ am Kondensator C vergleichbare Messergebnisse abgreifen zu können, sind die Messwiderstände R₁, R₂, R₃, R₄, R₅, R₆, R₇, R₈, R₉ bis Rₙ in ihrer Größe angepasst gewählt. So wird für den ersten Widerstand R₁ z. B. ein Wert von 10kΩ gewählt; die folgenden Messwiderstände R₂, R₃, R₄, R₅, R₆, R₇, R₈, R₉ bis Rₙ sind mit wachsenden Werten ausgebildet; bei zehn Messwiderständen Rₙ hat der letzte Messwiderstand Rₙ einen Wert von z. B. 100kΩ. Auf diese Weise werden die elektrischen Bedingungen zur Messung einer Einzelspannung Uᵢ an einer Einzelzelle Zᵢ abhängig von dem geschlossenen Schalter Sᵢ angepasst. Jeder aktive Messzweig ist so mit τ = R•C statisch kalibriert worden.

Der Messeingang 7 der Auswertevorrichtung 5 ist über einen Kondensator C mit dem Bezugspotenzial 3 verbunden. Über einen Schalter S_{K} und einen Ohm'schen Widerstand R_{K} ist der positive Anschluss des Kondensators C mit einer Kalibrierspannung 4 verbunden.

Es kann zweckmäßig sein, die Auswertevorrichtung 5 mit einem zweiten Messeingang und einem zweiten Messkondensator zu versehen, wodurch die Gesamtdauer der Messung aller z. B. zehn Einzelzellen verringert werden kann. So können auch bei größeren Akkumulatoren mit Anordnungen von einer größeren Anzahl von Einzelzellen ausreichend Messanordnungen zur Verfügung gestellt werden, die eine sichere elektrische Überwachung gewährleisten.

Jeder Messeingang wird zusammen mit dem zugeordneten Messkondensator C einzeln kalibriert, und die Werte der Kalibrierung werden vorteilhaft in einem Mikroprozessor 8 abgelegt. Vorteilhaft erfolgt eine dynamische Kalibrierung derart, dass nach jeder Messung ein Kalibrierprozess durchlaufen wird, so dass eine Alterung oder ein Temperaturdrift des Messkondensators C ausgeglichen wird.

Die zwischen dem Bezugspotenzial 3 und dem Messeingang 7 abzugreifende Kondensatorspannung Uc wird über einen Eingangswiderstand R_{M} einem Mikroprozessor 8 zugeführt.

Die Kondensatorspannung Uc wird auf einen ersten Eingang 6 eines Komparators 11 geschaltet. An dem anderen, zweiten Eingang 9 des Komparators liegt ein Referenzwert in Form einer vorgegebenen Messspannung U_{M} an.

Der Ausgang 12 des Komparators steuert einen Zähler 13, der die Impulse 15 eines Zeitgliedes 14 zählt. In einer Berechnungseinheit 16, der unmittelbar der Zählerstand des Zählers 13 übermittelt wird, wird anhand der gezählten Impulse 15 die Ladezeit t des Kondensators C auf die als Referenzwert vorgegebene Messspannung U_{M} ermittelt. Der Mikroprozessor 8 kann anhand der Ladezeit tᵢ auf die Zellspannung Uᵢ der gemessenen Einzelzelle Zᵢ schließen.

Wird z. B. die Zelle Z₁ durch Schließen des Schalters S₁ an den Messkondensator C angelegt, so wird mit Schließen des Schalters S₁ der Zähler 13 gestartet. Am Komparator 11 liegt einerseits die Kondensatorspannung Uc an; am anderen Eingang 9 des Komparators liegt die Messspannung U_{M} als Referenzwert an. Während des Aufladens des Kondensators C zählt der Zähler 13 die Impulse 15 des Zeitgliedes 14. Sobald die Kondensatorspannung Uc den Referenzwert der Messspannung U_{M} erreicht, wird über den Ausgang 12 des Komparators 11 der Zähler 13 gestoppt. Der Zählerstand ist proportional einer Zeit - hier der Ladezeit t₁ -, da der Zählerstand einer Anzahl von Impulsen 15 des Zeitgliedes 14 entspricht. Es ist eine normierte Ladung des Kondensators umgesetzt.

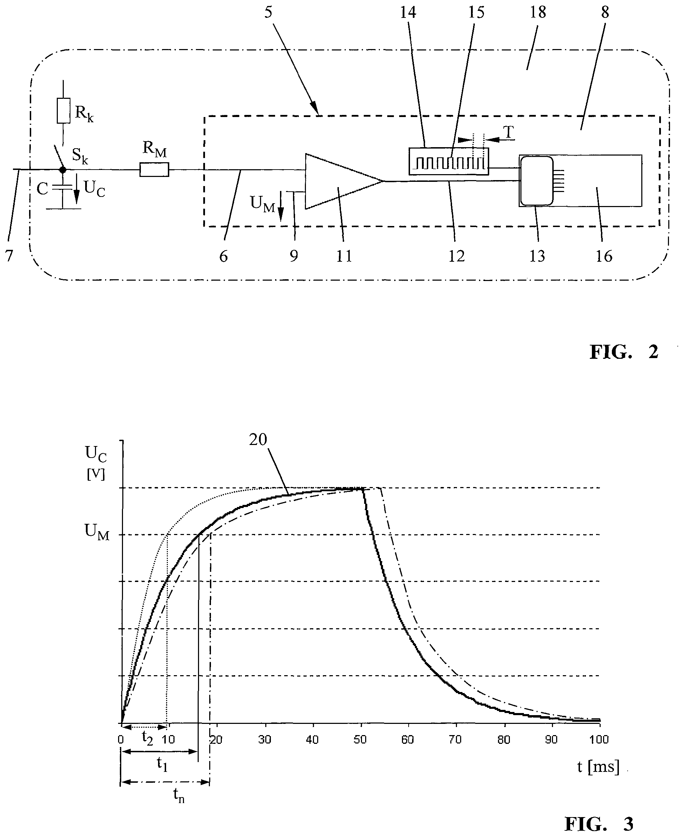

In Fig. 3 ist schematisch die Aufladung des Messkondensators C beispielhaft für verschiedene Ladekurven 20 wiedergegeben. Wie dargestellt, liegt die Messspannung U_{M} unterhalb einer maximalen Ladespannung des Kondensators C; für die Erfassung der Zellspannung Uᵢ einer Einzelzelle Zᵢ ist ausreichend, einen Teilzweig der Ladekurve 20 des Messkondensators C zu betrachten. Über den Zählerstand des Zählers 13 kann die Ladezeit tᵢ bestimmt werden, die benötigt wird, um den Messkondensator C auf die Messspannung U_{M} aufzuladen. So bestimmt die Auswertevorrichtung 5 z. B. anhand der über den Zähler 13 ermittelten Ladezeit t₁ die Zellspannung Ui der gemessenen Einzelzelle Z₁.

Da das Zeitglied 14 eine zeitstabile Impulsfolge aus Impulsen 15 bereitstellt, entspricht eine Zähleinheit des Zählers 13 einer vorgegebenen festen Zeiteinheit, nämlich einer Periode T der Impulse 15. Wird eine Impulsfolge mit hoher Frequenz gewählt, wird vom Zähler 13 eine große Anzahl von Impulsen 15 gezählt, wodurch bei einfachem Aufbau eine hohe Auflösung und eine hohe Genauigkeit zu erzielen sind. Es können Zählerstände von mehreren Tausend, Zehntausend oder Hunderttausend Einheiten erreicht werden, je nach gewählter Frequenz und Impulsfolge. Bei geringem Aufwand ist so eine hohe Genauigkeit erreichbar, die in dieser Güte mit einem A/D-Wandler mit vertretbarem Aufwand kaum möglich ist.

Die Auswertevorrichtung 5 zur Umrechnung des Zählerstandes des Zählers 13 in die Zellspannung Uᵢ der gemessenen Einzelzelle Zᵢ ist in einem Mikroprozessor 8 ausgebildet. Dabei bildet der Zähler 13 ein integriertes Bauteil des Mikroprozessors 8. In gleicher Weise bildet auch der Komparator 11 ein integriertes Bauteil des Mikroprozessors 8.

## Patentansprüche

1. Schaltungsanordnung mit einer Auswertevorrichtung (5) zur Bestimmung der Zellspannung (Uᵢ) einer Einzelzelle (Zᵢ) in einem Zellverbund aus einer Reihenschaltung (2) von Einzelzellen (Zᵢ) eines Akkupacks (1),
wobei zwischen elektrisch benachbarten Einzelzellen (Zᵢ) der Reihenschaltung (2) jeweils ein Potenzialpunkt (Pᵢ) ausgebildet ist, und die Potenziale der in der Reihenschaltung (2) aufeinander folgenden Potenzialpunkte (Pᵢ) ausgehend von einem Bezugspotenzial (3) im Betrag anwachsen,
wobei jeder Potenzialpunkt (Pᵢ) der Reihenschaltung (2) über einen Messwiderstand (Rᵢ) und einen Schalter (Sᵢ) mit einem Messeingang (7) der Auswertevorrichtung (5) verbunden ist,
wobei durch die Schaltungsanordnung (10) ein erster Potenzialpunkt (P₁) mit einem ersten Widerstand (R₁) mit dem Messeingang (7) verbunden ist, und die in der Reihe folgenden Potenzialpunkte (Pᵢ) der Schaltungsanordnung (10) über Messwiderstände (Rᵢ) mit anwachsenden Werten mit dem Messeingang (7) verbunden sind, und
die Schaltungsanordnung (10) ausgebildet ist, durch Schließen eines Schalters (Sᵢ) die Einzelspannungen (Uᵢ) einer Teilreihenschaltung der Einzelzellen (Zᵢ) als Summenspannung auf den Messeingang (7) zu schalten,
**dadurch gekennzeichnet,**
- **dass** der Messeingang (7) über einen Messkondensator (C) mit dem Bezugspotenzial (3) verbunden ist, und die Auswertevorrichtung (5) ausgebildet ist, die Ladezeit (tᵢ) des Messkondensators (C) auf eine vorgegebene Messspannung (U_{M}) zu erfassen,
- und **dass** die Auswertevorrichtung (5) ausgebildet ist, anhand der Ladezeit (tᵢ) des Messkondensators (C) und der Zeitkonstante des jeweiligen aktiven Messzweigs (Rᵢ^{∗}C) das Potenzial des Potenzialpunktes und die Zellspannung (Uᵢ) der Einzelzelle (Zᵢ) zu bestimmen.

2. Schaltungsanordnung nach Anspruch 1,
weiter ausgebildet, die Ladezeit (tᵢ) des Messkondensators (C) auf die Messspannung (U_{M}) mittels eines Zählers (13) zu erfassen, der mit dem Beginn der Messung anläuft und bei Erreichen der vorgegebenen Messspannung (U_{M}) stoppt.

3. Schaltungsanordnung nach Anspruch 2,
**dadurch gekennzeichnet, dass** der Zählerstand des Zählers (13) der Ladezeit (tᵢ) des Messkondensators (C) auf die Messspannung (U_{M}) proportional ist.

4. Schaltungsanordnung nach Anspruch 3,
**dadurch gekennzeichnet, dass** eine Zähleinheit des Zählers (13) einer vorgegebenen Zeiteinheit (tᵢ) entspricht.

5. Schaltungsanordnung nach Anspruch 4,
**dadurch gekennzeichnet, dass** der Zähler (13) die Impulse (15) eines Zeitgliedes (14) zählt.

6. Schaltungsanordnung nach Anspruch 2,
weiter ausgebildet, die Kondensatorspannung (Uc) des Messkondensators (C) auf einen ersten Eingang (6) eines Komparators (11) zu schalten, und auf einen zweiten Eingang (9) des Komparators ein Referenzwert entsprechend der vorgegebenen Messspannung (U_{M}) aufzuschalten.

7. Schaltungsanordnung nach Anspruch 6, weiter ausgebildet, den Ausgang (12) des Komparators (11) als Steuerungssignal auf den Zähler (13) zu schalten.

8. Schaltungsanordnung nach einem der Ansprüche 1 bis 7,
**dadurch gekennzeichnet, dass** die Auswertevorrichtung (5) zur Umrechnung des Zählerstandes in die Zellspannung (Uᵢ) der gemessenen Einzelzelle (Zᵢ) in einem Mikroprozessor (8) ausgebildet ist.

9. Schaltungsanordnung nach Anspruch 8,
**dadurch gekennzeichnet, dass** der Zähler (13) ein integriertes Bauteil des Mikroprozessors (8) ist.

10. Schaltungsanordnung nach Anspruch 7,
**dadurch gekennzeichnet, dass** ein Komparator zum Vergleich der Kondensatorspannung (Uc) des Messkondensators (C) mit einem Referenzwert als integriertes Bauteil des Mikroprozessors (8) ausgebildet ist.

11. Schaltungsanordnung nach Anspruch 9,
**dadurch gekennzeichnet, dass** der Zähler (13) den Takt eines internen Taktgebers des Mikroprozessors (8) zählt.

12. Schaltungsanordnung nach einem der Ansprüche 1 bis 11,
**dadurch gekennzeichnet, dass** die Messspannung (U_{M}) kleiner ist als die Zellspannung (Uᵢ) einer Einzelzelle (Zᵢ).

13. Schaltungsanordnung nach Anspruch 1,
**dadurch gekennzeichnet, dass** die Messwiderstände (Ri) in ihrer Größe derart gewählt sind, dass unabhängig von dem gewählten Schalter (Si) am Kondensator (C) vergleichbare Messergebnisse abgegriffen werden.

## Claims

1. Circuit arrangement having an evaluation apparatus (5) for determining the cell voltage (Uᵢ) of an individual cell (Zᵢ) in a cell assembly composed of a series circuit (2) comprising individual cells (Zᵢ) of a rechargeable battery pack (1),
wherein a potential point (Pᵢ) is formed in each case between electrically adjacent individual cells (Zᵢ) of the series circuit (2), and the potentials of the potential points (Pᵢ) which follow one another in the series circuit (2) increase in absolute value starting from a reference potential (3),
wherein each potential point (Pᵢ) of the series circuit (2) is connected to a measuring input (7) of the evaluation apparatus (5) via a measuring resistor (Rᵢ) and a switch (Sᵢ),
wherein, by virtue of the circuit arrangement (10), a first potential point (P₁) is connected to the measuring input (7) via a first resistor (Ri), and the potential points (Pᵢ) of the circuit arrangement (10) which follow in the series are connected to the measuring input (7) via measuring resistors (Rᵢ) having increasing values, and the circuit arrangement (10) is designed to connect the individual voltages (Uᵢ) of a partial series circuit comprising the individual cells (Zᵢ) to the measuring input (7) as a summed voltage by closing a switch (Sᵢ),
**characterized**
- **in that** the measuring input (7) is connected to the reference potential (3) via a measuring capacitor (C), and the evaluation apparatus (5) is designed to measure the charging time (tᵢ) of the measuring capacitor (C) at a predefined measuring voltage (U_{M}),
- and **in that** the evaluation apparatus (5) is designed to use the charging time (tᵢ) of the measuring capacitor (C) and the time constant of the respective active measuring branch (Rᵢ^{∗}C) as a basis for determining the potential of the potential point and the cell voltage (Uᵢ) of the individual cell (Zᵢ).

2. Circuit arrangement according to Claim 1,
further designed to measure the charging time (tᵢ) of the measuring capacitor (C) at the measuring voltage (U_{M}) by means of a counter (13) which starts when the measurement begins and stops when the predefined measuring voltage (U_{M}) is reached.

3. Circuit arrangement according to Claim 2,
**characterized in that** the reading on the counter (13) is proportional to the charging time (tᵢ) of the measuring capacitor (C) at the measuring voltage (U_{M}).

4. Circuit arrangement according to Claim 3,
**characterized in that** a counting unit of the counter (13) corresponds to a predefined time unit (tᵢ).

5. Circuit arrangement according to Claim 4,
**characterized in that** the counter (13) counts the pulses (15) of a timing element (14).

6. Circuit arrangement according to Claim 2,
further designed to connect the capacitor voltage (Uc) of the measuring capacitor (C) to a first input (6) of a comparator (11), and to connect a reference value corresponding to the predefined measuring voltage (U_{M}) to a second input (9) of the comparator.

7. Circuit arrangement according to Claim 6,
further designed to connect the output (12) of the comparator (11) to the counter (13) as a control signal.

8. Circuit arrangement according to one of Claims 1 to 7,
**characterized in that** the evaluation apparatus (5) is designed to convert the counter reading into the cell voltage (Uᵢ) of the measured individual cell (Zᵢ) in a microprocessor (8).

9. Circuit arrangement according to Claim 8,
**characterized in that** the counter (13) is an integrated component of the microprocessor (8).

10. Circuit arrangement according to Claim 7,
**characterized in that** a comparator for comparing the capacitor voltage (Uc) of the measuring capacitor (C) with a reference value is in the form of an integrated component of the microprocessor (8).

11. Circuit arrangement according to Claim 9,
**characterized in that** the counter (13) counts the cycle of an internal clock of the microprocessor (8).

12. Circuit arrangement according to one of Claims 1 to 11,
**characterized in that** the measuring voltage (U_{M}) is less than the cell voltage (Uᵢ) of an individual cell (Zᵢ).

13. Circuit arrangement according to Claim 1,
**characterized in that** the magnitude of the measuring resistors (Ri) is selected in such a way that comparable measurement results are tapped at the capacitor (C) irrespective of the selected switch (Si).

## Revendications

1. Arrangement de circuit comprenant un dispositif d'interprétation (5) destiné à déterminer la tension de cellule (Uᵢ) d'une cellule individuelle (Zᵢ) dans un groupe de cellules composé d'un circuit série (2) de cellules individuelles (Zᵢ) d'un bloc d'accumulateur (1),
un point de potentiel (Pᵢ) étant respectivement formé entre des cellules individuelles (Zᵢ) électriquement voisines du circuit série (2) et les potentiels des points de potentiel (Pᵢ) successifs dans le circuit série (2) augmentant en valeur à partir d'un potentiel de référence (3),
chaque point de potentiel (Pᵢ) du circuit série (2) étant relié à une entrée de mesure (7) du dispositif d'interprétation (5) par le biais d'une résistance de mesure (Rᵢ) et d'un commutateur (Sᵢ),
un premier point de potentiel (P₁) étant relié par le biais de l'arrangement de circuit (10) à l'entrée de mesure (7) par une première résistance (R₁) et les points de potentiel (Pᵢ) de l'arrangement de circuit (10) qui suivent dans la série étant reliés à l'entrée de mesure (7) par le biais de résistances de mesure (Rᵢ) ayant des valeurs croissantes, et
l'arrangement de circuit (10) est configuré pour, par la fermeture d'un commutateur (Sᵢ), commuter les tensions individuelles (Uᵢ) d'un circuit série partiel des cellules individuelles (Zᵢ) en tant que tension totale sur l'entrée de mesure (7),
**caractérisé en ce**
- **que** l'entrée de mesure (7) est reliée au potentiel de référence (3) par le biais d'un condensateur de mesure (C), et le dispositif d'interprétation (5) est configuré pour acquérir le temps de charge (tᵢ) du condensateur de mesure (C) à une tension de mesure (U_{M}) prédéfinie,
- et en ce que le dispositif d'interprétation (5) est configuré pour déterminer, à l'aide du temps de charge (tᵢ) du condensateur de mesure (C) et de la constante de temps de la branche de mesure (Rᵢ^{∗}C) respectivement active, le potentiel du point de potentiel et la tension de cellule (Uᵢ) de la cellule individuelle (Zᵢ).

2. Arrangement de circuit selon la revendication 1,
configuré en outre pour acquérir le temps de charge (tᵢ) du condensateur de mesure (C) à la tension de mesure (U_{M}) au moyen d'un compteur (13), lequel démarre au début de la mesure et s'arrête lorsque la tension de mesure (U_{M}) prédéfinie est atteinte.

3. Arrangement de circuit selon la revendication 2,
**caractérisé en ce que** l'état de comptage du compteur (13) est proportionnel au temps de charge (tᵢ) du condensateur de mesure (C) à la tension de mesure (U_{M}).

4. Arrangement de circuit selon la revendication 3,
**caractérisé en ce qu'**une unité de comptage du compteur (13) correspond à une unité de temps (tᵢ) prédéfinie.

5. Arrangement de circuit selon la revendication 4,
**caractérisé en ce que** le compteur (13) compte les impulsions (15) d'un temporisateur (14).

6. Arrangement de circuit selon la revendication 2,
configuré en outre pour commuter la tension de condensateur (Uc) du condensateur de mesure (C) sur une première entrée (6) d'un comparateur (11) et commuter une valeur de référence correspondant à la tension de mesure (U_{M}) prédéfinie sur une deuxième entrée (9) du comparateur.

7. Arrangement de circuit selon la revendication 6,
configuré en outre pour commuter la sortie (12) du comparateur (11) sur le compteur (13) en tant que signal de commande.

8. Arrangement de circuit selon l'une des revendications 1 à 7,
**caractérisé en ce que** le dispositif d'interprétation (5) est réalisé dans un microprocesseur (8) en vue de convertir l'état de comptage en la tension de cellule (Uᵢ) de la cellule individuelle (Zᵢ).

9. Arrangement de circuit selon la revendication 8,
**caractérisé en ce que** le compteur (13) est un composant intégré du microprocesseur (8).

10. Arrangement de circuit selon la revendication 7,
**caractérisé en ce qu'**un comparateur destiné à comparer la tension de condensateur (Uc) du condensateur de mesure (C) avec une valeur de référence est réalisé sous la forme d'un composant intégré du microprocesseur (8).

11. Arrangement de circuit selon la revendication 9,
**caractérisé en ce que** le compteur (13) compte le cycle d'un générateur de rythme interne du microprocesseur (8).

12. Arrangement de circuit selon l'une des revendications 1 à 11,
**caractérisé en ce que** la tension de mesure (U_{M}) est inférieure à la tension de cellule (Uᵢ) d'une cellule individuelle (Zᵢ).

13. Arrangement de circuit selon la revendication 1,
**caractérisé en ce que** les résistances de mesure (Ri) sont choisies au niveau de leur taille de telle sorte que des résultats de mesure comparables sont prélevés au niveau du condensateur (C) indépendamment du commutateur (Si) sélectionné.
